(19) Europäisches Patentamt
European Patent Office
Office européen des brevets

(11) EP 2 275 222 B1

(12) **EUROPEAN PATENT SPECIFICATION**

(45) Date of publication and mention
of the grant of the patent:
**24.04.2013 Bulletin 2013/17**

(51) Int Cl.:
*B23K 26/06* (2006.01)   *B23K 26/08* (2006.01)
*B23K 26/00* (2006.01)   *G02B 27/09* (2006.01)
*B23K 101/40* (2006.01)

(21) Application number: **10013508.6**

(22) Date of filing: **10.07.2007**

(54) **Laser irradiation apparatus and methods using a beam expander with two lenses, the position of the latter with respect to the laser oscillator governed by an equation**

Laserbestrahlungsgerät und -verfahren mit einem zwei Linsen aufweisenden Strahlaufweiter, die Linsenlagerung gegenüber den Laseroszillator durch eine Gleichung gesteuert

Appareil et procédés d'irradiation par laser avec un expenseur comprenant deux lentilles, la position des lentilles vis-à-vis de la source laser gouvernée par une équation

(84) Designated Contracting States:
**DE FI FR GB NL**

(30) Priority: **14.07.2006 JP 2006193553**

(43) Date of publication of application:
**19.01.2011 Bulletin 2011/03**

(62) Document number(s) of the earlier application(s) in accordance with Art. 76 EPC:
**07013499.4 / 1 878 530**

(73) Proprietor: **Semiconductor Energy Laboratory Co., Ltd.**
**Atsugi-shi, Kanagawa-ken 243-0036 (JP)**

(72) Inventor: **Tanaka, Koichiro**
**Atsugi-shi**
**Kanagawa-ken 243-0036 (JP)**

(74) Representative: **Grünecker, Kinkeldey,**
**Stockmair & Schwanhäusser**
**Leopoldstrasse 4**
**80802 München (DE)**

(56) References cited:
**EP-A- 1 666 949    EP-A- 1 808 723**
**FR-A1- 2 731 085    US-A1- 2002 163 730**
**US-B1- 6 473 233    US-B1- 6 643 300**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The present invention relates to a laser irradiation apparatus and a laser irradiation method according to the preamble of claims 1 and 4 respectively (see, for example, US 6 473 233 B1), and particularly relates to a laser irradiation apparatus and a laser irradiation method using a beam expander optical system.

2. Description of the Related Art

Recently, a technique for manufacturing thin film transistors (hereinafter referred to as TFTs) over a substrate has been drastically advanced and developed for an active matrix display device. In particular, TFTs using a polycrystalline semiconductor film have a higher field-effect mobility (also referred to as a mobility) than conventional TFTs using an amorphous semiconductor film; accordingly, high-speed operation is possible. Therefore, although in a conventional manner, pixels have been controlled by a driver circuit which is provided outside a substrate, pixels can be controlled by a driver circuit formed over the same substrate as the pixels.

As a substrate used for a semiconductor device, glass substrates are expected to be more promising than quartz substrates and single-crystalline semiconductor substrates in terms of cost. However, such glass substrates have poorer heat resistance and are easily deformed by heat. Therefore, when a semiconductor film is crystallized in order to form a TFT using a polycrystalline semiconductor film over a glass substrate, a method for crystallizing a semiconductor film by laser irradiation is often employed to avoid thermal deformation of the glass substrate.

Features of the crystallization of a semiconductor film by laser light are such that, compared with an annealing method utilizing radiation heating or conductive heating, processing time can be drastically reduced, a semiconductor substrate or a semiconductor film over a substrate is selectively or locally heated so that the substrate is hardly damaged by heat.

Generally, laser light emitted from a laser oscillator has a Gaussian spatial intensity distribution. Therefore, if an irradiation object is directly irradiated with laser light emitted from a laser oscillator, the energy distribution varies in the irradiated region of the irradiation object. For example, when crystallization or improvement of film quality is conducted by irradiating a semiconductor film of silicon or the like with laser light, if the semiconductor film is directly irradiated with such laser light having a Gaussian spatial intensity distribution, the energy distribution is different between a central portion and an end portion of the irradiated region, so that melt time of the semiconductor film also varies. Consequently, crystallinity of the semiconductor film becomes nonuniform, and a semiconductor film having a desired characteristic cannot be obtained.

US 6 473 233 B1 discloses a multi-beam optical system, capable of avoiding defects caused by the wavelength dependency of a diffractive beam dividing element employed therein.

EP 1 666 949 A discloses a laser irradiation apparatus which can form a linear beam spot having a long side direction and a short side direction.

FR 2 731 085 A1 discloses a fast responding optical modulating device for a high density recording using in an optical pickup includes a light source, an optical modulator and a pair of lenses.

Accordingly, in general, after the spatial intensity distribution of laser light emitted from a laser oscillator is uniformed by using some kind of laser light shaping means, an irradiation object is irradiated with the laser light. For example, as the laser light shaping means, a beam expander optical system is widely used (for example, Japanese Published Patent Application No. H7-41845).

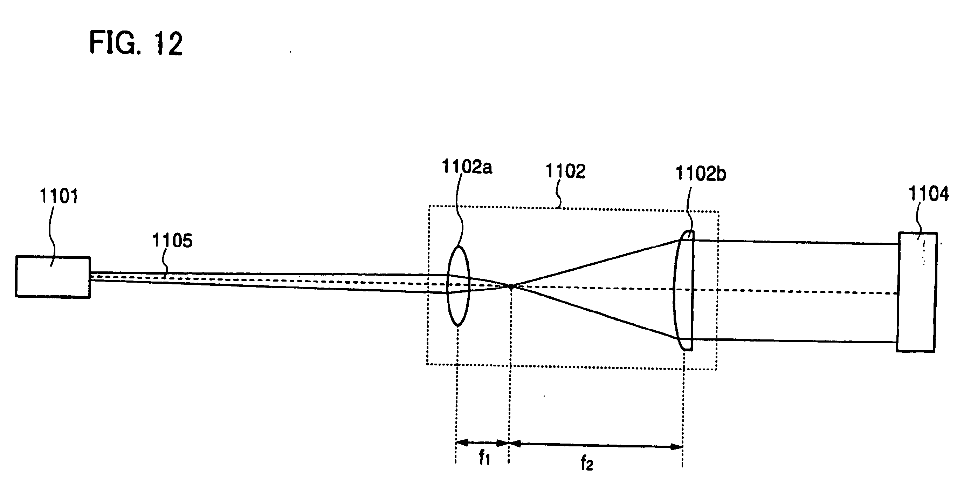

A conventional beam expander optical system includes two lenses 1102a, 1102b as shown in FIG. 12. When the focal length of the lens 1102a is $f_1$ and the focal length of the lens 1102b is $f_2$, the optical length between the lens 1102a and the lens 1102b is $f_1 + f_2$ in the conventional beam expander optical system. Laser light 1105 emitted from a laser oscillator 1101 passes through a beam expander optical system 1102 such that it is expanded $f_2/f_1$ times and is projected. For example, a diffractive optical element 1104 is arranged behind the beam expander optical system to obtain laser light having a desired shape.

In general, since the diffractive optical element has a minute and complicated structure, it is necessary that laser light enters the element at an extremely accurate position. Since it is now extremely difficult to reduce the diameter of the diffractive optical element, laser light is expanded by a beam expander optical system or the like, and transferred to a diffractive optical element as described above.

SUMMARY OF THE INVENTION

Laser light which has entered a conventional beam expander optical system is changed in the beam size in accordance with the magnification X of the beam expander optical system, and exits from the beam expander optical system. At that time, if the beam enters accurately at the center of the lens 1102a, which is located at the entrance of the beam expander optical system, the expanded laser light exits from the center of the lens 1102b located at the exit point, and the laser light enters the diffractive optical element 1104 accurately (FIG 12).

However, laser light is unstable light, since the optical path of the laser light is often varied depending on a laser oscillator itself or a state of operating environment or the change of the operating environment such as temperature change. Thus, when laser light enters the beam expander optical system, undesirably, the laser light does not enter the center of the first lens accurately and displacement of the entrance point (entrance error) into the diffractive optical element may be observed.

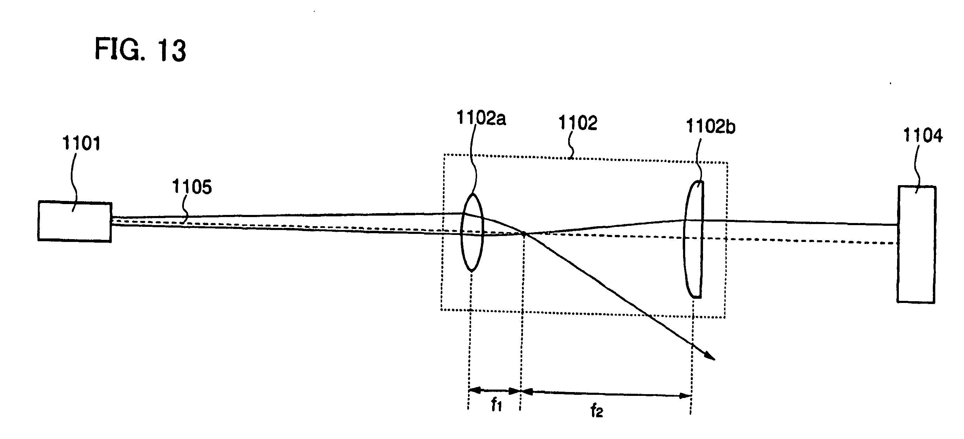

For example, when the magnification of the beam expander optical system is X and the entrance point of the laser light into the first lens is apart from the center of the lens by "d", the exit point of the laser light from the second lens is apart from the center of the lens by "Xd" (FIG. 13). In other words, the difference of entrance point of laser light into the beam expander optical system is expanded by the expansion magnification of laser light, which is regarded as displacement of the exit point. Accordingly, the entrance point into the diffractive optical element is also apart from the center by the distance "Xd". This may cause a problem in that laser light having desired performance cannot be obtained, when a diffractive optical element which needs accurate entrance point of laser light is used.

For example, the pointing stability of a solid-state laser is about several tens $\mu$rad, and thus, the entrance point of the laser light into the beam expander optical system is apart from the center in the range of about 100 $\mu$m, when the optical path length is several m. Thus, when the magnification of the beam expander optical system is 10 times, the exit point of the laser light from the beam expander optical system is apart from the center in the range of about 1 mm.

The present invention has been made in view of the problems. It is an object of the present invention to provide a laser irradiation apparatus and a laser irradiation method which can reduce an error of entrance point of laser light into a diffractive optical element, in the case where laser light enters the diffractive optical element through a beam expander optical system.

A laser irradiation apparatus of the present invention includes a laser oscillator; a beam expander optical system which receives laser light emitted from the laser oscillator; and a diffractive optical element which receives laser light transmitted through the beam expander optical system. In the laser irradiation apparatus, the beam expander optical system includes a first lens and a second lens in this order from the laser oscillator side, and equations $c = f_1$, $d = f_1 + f_2$, and $e = f_2$ are satisfied, where "c" is an optical length between an emission point of the laser oscillator and the first lens, "d" is an optical length between the first lens and the second lens, "e" is an optical length between the second lens and the diffractive optical element, $f_1$ is a focal length of the first lens, and $f_2$ is a focal length of the second lens.

In the laser irradiation apparatus of the present invention, the optical length between the emission point of the laser oscillator and the second lens is one meter or longer.

In the laser irradiation apparatus of the present invention, the first lens and the second lens are convex lenses.

A laser irradiation method of the present invention includes the steps of emitting laser light from a laser oscillator; allowing the laser light to enter a beam expander optical system including a first lens and a second lens which are provided in this order from the laser oscillator side; and allowing the laser light which have passed through the beam expander optical system to enter the diffractive optical element. At that time, the laser oscillator, the first lens, the second lens, and the diffractive optical element are arranged so that equations $c = f_1$, $d = f_1 + f_2$, and $e = f_2$ are satisfied, where "c" is an optical length between an emission point of the laser oscillator and the first lens, "d" is an optical length between the first lens and the second lens, "e" is an optical length between the second lens and the diffractive optical element, $f_1$ is a focal length of the first lens, and $f_2$ is a focal length of the second lens.

In the laser irradiation method of the present invention, the optical length between the emission point of the laser oscillator and the second lens is one meter or longer.

In the laser irradiation method of the present invention, the first lens and the second lens are convex lenses.

A feature of a laser irradiation apparatus of the present invention is that, when the scale of laser light emitted from a laser oscillator is enlarged through a beam expander optical system including two lenses, and the laser light enters the diffractive optical element, the emission point of the laser light and the first and second lenses are arranged such that the positions of the emission point of the laser light and the second lens are conjugate to each other by the first lens. Thus, displacement of entrance point into the second lens due to the emission angle change of the laser light is reduced, and displacement of entrance point of the laser light into the diffractive optical element can also be reduced.

In the laser irradiation apparatus of the present invention, the laser light is collimated by the second lens. Thus, the position of the diffractive optical element is not particularly limited and the anteroposterior position displacement of the diffractive optical element causes almost no change in the performance of the laser light.

BRIEF DESCRIPTION OF DRAWINGS

In the accompanying drawings:

FIG 1 illustrates an example of a laser irradiation apparatus not covered by the present invention;
FIG. 2 illustrates an example of a laser irradiation apparatus of the present invention;
FIG. 3 illustrates an example of a laser irradiation apparatus of the present invention;
FIGS. 4A to 4D illustrate an example of a manufacturing process of a semiconductor device, using a laser irradiation apparatus of the present invention;
FIGS. 5A to 5C illustrate an example of a manufacturing process of a semiconductor device, using a laser irradiation apparatus of the present invention;

FIGS. 6A and 6B illustrate an example of a manufacturing process of a semiconductor device, using a laser irradiation apparatus of the present invention;
FIGS. 7A and 7B illustrate an example of a manufacturing process of a semiconductor device, using a laser irradiation apparatus of the present invention;
FIGS. 8A and 8B illustrate an example of a manufacturing process of a semiconductor device, using a laser irradiation apparatus of the present invention;
FIGS. 9A to 9C illustrate examples of usage modes of a semiconductor device manufactured with a laser irradiation apparatus of the present invention;
FIGS. 10A to 10D illustrate examples of antennas of a semiconductor device manufactured with a laser irradiation apparatus of the present invention;
FIGS. 11A to 11H illustrate examples of usage modes of a semiconductor device manufactured with a laser irradiation apparatus of the present invention;
FIG 12 illustrates an example of a conventional laser irradiation apparatus; and
FIG 13 illustrates an example of a conventional laser irradiation apparatus.

DETAILED DESCRIPTION OF THE INVENTION

Embodiment modes of the present invention will be described with reference to the drawings. Note that it is easily understood by those skilled in the art that the present invention is not limited to the following description and various changes may be made in modes and details without departing from the spirit and the scope of the present invention. Therefore, the present invention should not be limited to the descriptions of the embodiment modes below. In addition, in the structures of the present invention described below, the same reference numerals are commonly given to the same components or components having the same function in some cases.

Example Mode 1

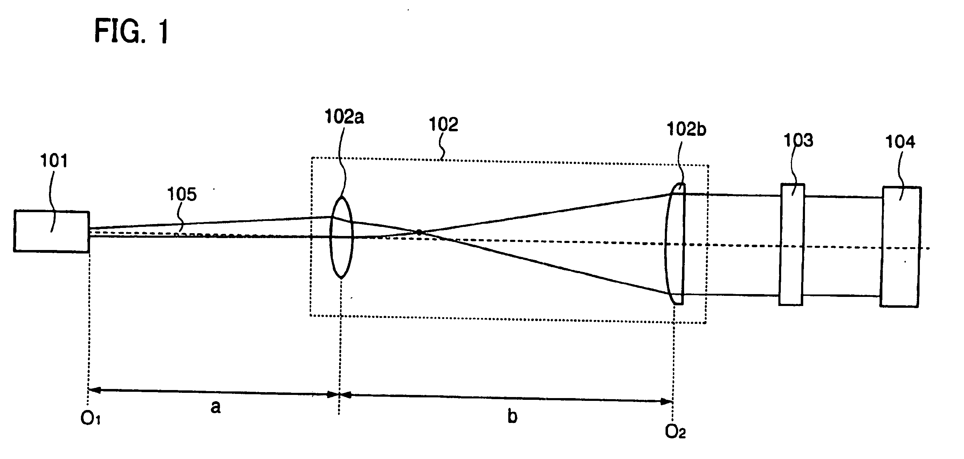

Mode 1 will describe one example of a laser irradiation apparatus and a laser irradiation method with reference to drawings.
First, FIG 1 illustrates a structural example of a laser irradiation apparatus described in this mode. The laser irradiation apparatus shown in FIG 1 includes at least a laser oscillator 101, a beam expander optical system 102, and a diffractive optical element 103. Laser light 105 emitted from the laser oscillator 101 is propagated to the diffractive optical element 103 through the beam expander optical system 102, the light passes through the diffractive optical element 103, and an irradiation object 104 is irradiated with the laser light 105 (FIG 1).
As the beam expander optical system 102 in the laser irradiation apparatus described in this mode, a convex lens and a convex lens can be combined. In FIG 1, a first convex lens 102a and a second convex lens 102b are disposed in order in a traveling direction of the laser light 105 which is emitted from the laser oscillator 101. Although FIG 1 illustrates an example of using a biconvex lens as the first convex lens 102a and using a plano-convex lens as the second convex lens 102b, the present invention is not limited to this example. A plano-convex lens, a convex meniscus lens, or the like may also be used as the first convex lens 102a, and a biconvex lens, a convex meniscus lens, or the like may also be used as the second convex lens 102b. Naturally, the first convex lens 102a and the second convex lens 102b may be of different kinds of lenses, or a compound lens of two or more lenses may alternatively be used.
As a laser capable of being used as the laser oscillator 101, a continuous-wave laser (CW laser) such as a $YVO_4$ laser, a quasi-CW laser, or the like can be used. For example, as a gas laser, there is an Ar laser, a Kr laser, a $CO_2$ laser, or the like, and as a solid-state laser, there is a YAG laser, a YLF laser, a $YAlO_3$ laser, a $GdVO_4$ laser, an alexandrite laser, a Ti:sapphire laser, a ceramics laser typified by a $Y_2O_3$ laser, or the like. As a metal vapor laser, there is a helium-cadmium laser or the like. Alternatively, a disk laser may also be used. A feature of the disk laser is that cooling efficiency is excellent because a laser medium has a disk shape, namely that energy efficiency and beam quality are excellent.
Laser light emitted from the above-described laser oscillator is preferably emitted in $TEM_{00}$ so that a linear beam spot obtained at an irradiation surface can have higher uniformity of energy.
The laser light which has passed through the diffractive optical element 103 is propagated to the irradiation object 104. The diffractive optical element 103 is also referred to as a diffractive optic element or a diffractive optics, and an element which can obtain a spectrum using optical diffraction can be used.
In the laser irradiation apparatus shown in FIG. 1, the emission point of the laser oscillator 101 (in general, the emission point is preferably a beam waist or a laser emission port) is regarded as a first conjugate point $O_1$, and a point at which an light from the first conjugate point $O_1$ is imaged through the first convex lens 102a is regarded as a second conjugate point $O_2$. In this mode, the optical length between the first conjugate point $O_1$ and the first convex lens 102a is "a", the optical length between the firs convex lens 102a and the second convex lens 102b is "b", the focal length of the first convex lens 102a is $f_1$. In this case, the laser oscillator 101, the first convex lens 102a, and the second convex lens 102b are arranged so as to satisfy the following equation 1. In this embodiment mode, the light from the first conjugate point $O_1$ is imaged at the second convex lens 102b, and thus the optical length between the first convex lens 102a and the second convex lens $O_2$ is "b". In this embodiment mode, when the traveling direction of the laser light is Z-axis, movement of the laser light in X-Y plane is observed and a point at which the laser light emitted from the laser oscillator moves least is regarded as an emission point.
$$\frac{1}{f_1} = \frac{1}{a} + \frac{1}{b}$$

[0040]

The laser oscillator and the lenses are arranged such that this equation 1 is satisfied. In that case, the emission point of the laser light and the position of the second convex lens 102b are conjugate to each other by the first convex lens 102a. Thus, displacement of entrance point into the second convex lens 102b due to the emission angle change of the laser light is reduced, and displacement of entrance point of the laser light into the diffractive optical element 103 can also be reduced. Accordingly, the use of the laser irradiation apparatus described in this embodiment mode can provide laser light having desired performance.

The laser oscillator and the lenses are arranged such that the above equation is satisfied and an equation, $b=f_1+f_2$, is also satisfied when the focal length of the second convex lens 102b is $f_2$. The laser light is collimated by the second convex lens 102b. At that time, even if the diffractive optical element is arranged in any position behind the second convex lens 102b, the performance of the laser light is not so changed, and the anteroposterior displacement of the diffractive optical element causes almost no change in the performance of the laser light.

At that time, the size of the laser light at the second convex lens 102b is X times as large as that of the laser light at the first conjugate point $O_1$, X = b/a. In this embodiment mode, the variation of the exit angle of the laser light transmitted through the second convex lens 102b is 1/X of the pointing stability of the laser oscillator, and thus the laser irradiation apparatus of this embodiment mode becomes more effective as the magnification X of the beam expander increases.

In addition, the laser irradiation apparatus or the laser irradiation method described in this mode exhibits more significant effects, as the optical length between the laser oscillator 101 and the beam expander optical system 102 becomes longer. In general, when an optical system is used, an optical system should be arranged with a certain distance from another optical system, in consideration of the layout in the apparatus. The laser irradiation apparatus described in this mode is particularly effective when the optical length between the emission point of the laser oscillator 101 and the second convex lens 102b as a component of the beam expander optical system 102 is one meter or more.

This mode can be applied to all kinds of laser irradiation apparatuses and laser irradiation methods in which a beam expander optical system and a diffractive optical element are used.

Further, a slit optical system may be adopted instead of the diffractive optical element. In such a slit optical system, for example, two convex cylindrical lenses can be arranged behind the slit. The slit optical system is particularly effective in forming linear laser light or rectangular laser light. If the slit is arranged at the position of the diffractive optical element, laser light does not move at the position of the slit. Thus, the position of laser light to be cut by the slit is fixed and in particular, an energy attenuation region at the opposite end portions in the longitudinal-axis direction can be cut as necessary. Then, the laser light is shaped into a desired shape by the two convex cylindrical lenses which affect the linear or rectangular laser light in the longitudinal-axis direction and the short-axis direction, so that a surface can be irradiated with the laser light. One of the two convex cylindrical lenses affects the linear or rectangular laser light in the longitudinal-axis direction to project an image made by the slit on an irradiation surface. The other of the two convex cylindrical lenses affects the linear or rectangular laser light in the short-axis direction to shape the laser light. Note that instead of such convex cylindrical lenses, other lenses which have the same effect on laser light may be used.

As just described, a slit optical system is arranged such that laser light is fixed at a position of the slit, thereby easily forming linear or rectangular laser light whose energy attenuation region is cut on an irradiation surface. For example, when a surface of a semiconductor is crystallized by laser light, if the end portions of linear or rectangular laser light have insufficient energy, a micro crystal region is formed due to incompletely melting. However, the laser irradiation apparatus described in this embodiment mode can conduct laser irradiation after end portions of a linear or rectangular laser beam, whose energy is not sufficient, are cut. Therefore, a semiconductor film can be crystallized favorably.

Embodiment Mode 2

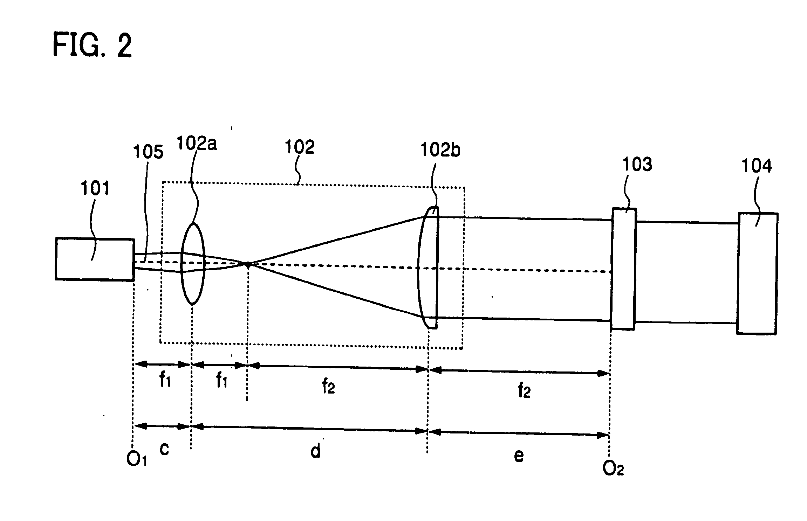

Embodiment Mode 2 will describe an example of a laser irradiation apparatus and a laser irradiation method according to the present invention, which are different from those illustrated in FIG 1, with reference to FIG 2.

One structural example of the laser irradiation apparatus described in this embodiment mode is shown in FIG 2. The laser irradiation apparatus shown in FIG 2 includes at least a laser oscillator 101, a beam expander optical system 102, and a diffractive optical element 103. Laser light 105 emitted from the laser oscillator 101 is propagated to the diffractive optical element 103 through the beam expander optical system 102, and an irradiation object 104 is irradiated with the laser light which have passed through the diffractive optical element 103 (FIG 2). The laser oscillator 101, the beam expander optical system 102, and the diffractive optical element 103 used in this embodiment mode may be similar to those in Embodiment Mode 1.

In the laser irradiation apparatus shown in FIG 2, the emission point of the laser oscillator 101 (in general, the emission point is preferably a beam waist or laser emission port) is regarded as a first conjugate point $O_1$, and a point at which light from the first conjugate point $O_1$ is imaged through the first convex lens 102a and the second convex lens 102b is regarded as a second conjugate point $O_2$. In this embodiment mode, the optical length between the first conjugate point $O_1$ and the first convex lens 102a is "c", the optical length between the first convex lens 102a and the second convex lens 102b is "d", the optical length between the second convex lens 102b and the second conjugate point $O_2$ is "e", the focal length of the first convex lens 102a is $f_1$, and the focal length of the second convex lens 102b is $f_2$. In this case, the laser oscillator 101, the first convex lens 102a, the second convex lens 102b, and the diffractive optical element 103 are arranged so as to satisfy the following equations 2, 3, and 4. In this embodiment mode, light from the first conjugate point $O_1$ is imaged at the diffractive optical element 103, and thus the optical length between the second convex lens 102b and the diffractive optical element 103 is "e".

$$c = f_1$$

$$d = f_1 + f_2$$

$$e = f_2$$

The laser oscillator, the lenses, and the diffractive optical element 103 are arranged such that these equations 2, 3, and 4 are satisfied. In that case, the emission point of the laser light and the position of the diffractive optical element 103 are conjugate to each other by the first convex lens 102a. Thus, displacement in entrance position of the laser light into the diffractive optical element 103, which is caused by the change in emission angle of the laser light, can also be reduced. Accordingly, the use of the laser irradiation apparatus described in this embodiment mode can provide laser light having desired performance.

At that time, the size of the laser light at the second convex lens 102b is X times as large as that of the laser light at the first conjugate point $O_1$, X = b/a. In this embodiment mode, the variation of the exit angle of the laser light transmitted through the second convex lens 102b is 1/X of the pointing stability of the laser oscillator, and thus the laser irradiation apparatus of this embodiment mode becomes more effective as the magnification X of the beam expander increases.

In addition, the laser irradiation apparatus or the laser irradiation method described in this embodiment mode exhibits more significant effects, as the optical length between the laser oscillator 101 and the beam expander optical system 102 becomes longer. In general, when an optical system is used, an optical system should be arranged with a certain distance from another optical system, in consideration of the layout in the apparatus. The laser irradiation apparatus described in this embodiment mode is particularly effective when the optical length between the emission point of the laser oscillator 101 and the second convex lens 102b as a component of the beam expander optical system 102 is one meter or more.

This embodiment mode can be applied to all kinds of laser irradiation apparatuses and laser irradiation methods in which a beam expander optical system and a diffractive optical element are used.

Further, a slit optical system may be adopted instead of the diffractive optical element. In such a slit optical system, for example, two convex cylindrical lenses can be arranged behind the slit. The slit optical system is particularly effective in forming linear laser light or rectangular laser light. If the slit is arranged at the position of the diffractive optical element, laser light does not move at the position of the slit. Thus, the position of laser light to be cut by the slit is fixed and in particular, an energy attenuation region at the opposite end portions in the longitudinal-axis direction can be cut as necessary. Then, the laser light is shaped into a desired shape by the two convex cylindrical lenses which affect the linear or rectangular laser light in the longitudinal-axis direction and the short-axis direction, so that a surface can be irradiated with the laser light. One of the two convex cylindrical lenses affects the linear or rectangular laser light in the longitudinal-axis direction to project an image made by the slit on an irradiation surface. The other of the two convex cylindrical lenses affects the linear or rectangular laser light in the short-axis direction to shape the light. Note that instead of such convex cylindrical lenses, other lenses which have the same effect on laser light may be used.

As just described, a slit optical system is arranged such that laser light is fixed at a position of the slit, thereby easily forming linear or rectangular laser light whose energy attenuation region is cut on an irradiation surface. For example, when a surface of a semiconductor is crystallized by laser light, if the end portions of linear or rectangular laser light have insufficient energy, a micro crystal region is formed due to incompletely melting. However, the laser irradiation apparatus described in this embodiment mode can conduct laser irradiation after end portions of a linear or rectangular laser beam, whose energy is not sufficient, are cut. Therefore, a semiconductor film can be crystallized favorably.

Embodiment Mode 3

Embodiment Mode 3 will describe a manufacturing method of a semiconductor device by the laser irradiation apparatus or the laser irradiation method described in the above-described embodiment mode 2, with reference to drawings.

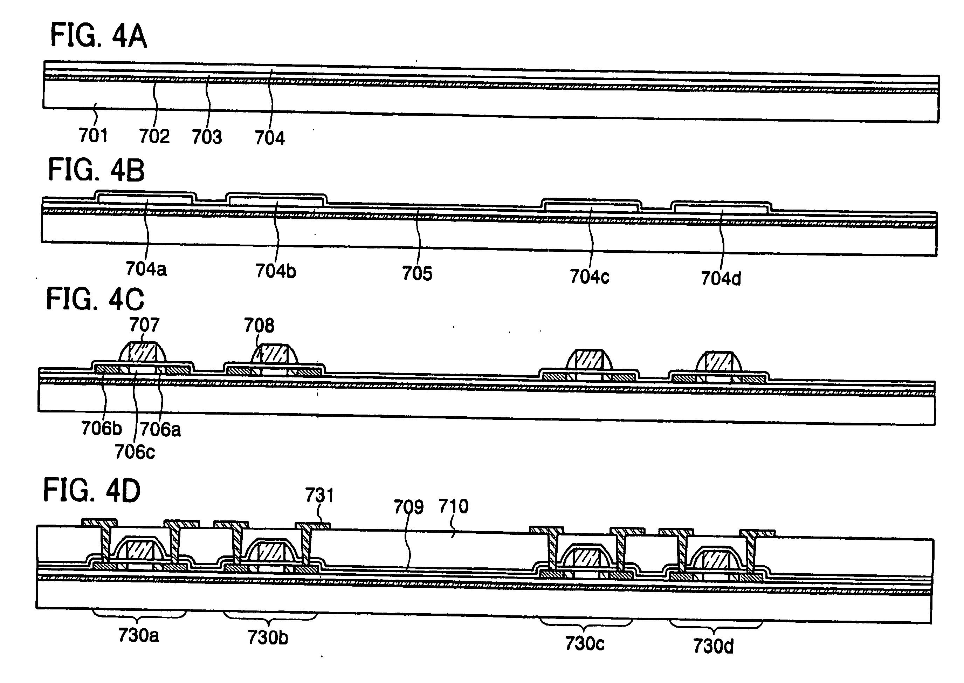

First, a peeling layer 702 is formed over a surface of a substrate 701, and sequentially, an insulating film 703 to be a base and an amorphous semiconductor film 704 (a film containing amorphous silicon, for example) are formed (FIG. 4A). It is to be noted that the peeling layer 702, the insulating film 703, and the amorphous semiconductor film 704 can be formed sequentially.

As the substrate 701, a glass substrate, a quartz substrate, a metal substrate, or a stainless steel substrate, with an insulating film formed over a surface thereof, a plastic substrate having heat resistance against the treatment temperature of this process, or the like may be used. With such a substrate 701, an area and a shape thereof are not particularly restricted; therefore, by using a rectangular substrate with at least one meter on a side as the substrate 701, for example, the productivity can be drastically improved. Such merit is greatly advantageous as compared to a case of using a circular silicon substrate. It is to be noted that, the peeling layer 702 is formed over an entire surface of the substrate 701 in this process; however, the peeling layer may be formed over the entire surface of the substrate 701, and then the peeling layer may be etched in a photolithography process to selectively form the peeling layer 702 as needed. In addition, the peeling layer 702 is formed so as to be in contact with the substrate 701; however, an insulating film may be formed as a base to be in contact with the substrate 701 as needed, and the peeling layer 702 may be formed so as to be in contact with the insulating film.

As the peeling layer 702, a metal film, a stacked layer structure of a metal film and a metal oxide film, or the like can be used. The metal film is formed as a single layer or stacked layers of a film formed of an element selected from tungsten (W), molybdenum (Mo), titanium (Ti), tantalum (Ta), niobium (Nb), nickel (Ni), cobalt (Co), zirconium (Zr), zinc (Zn), ruthenium (Ru), rhodium (Rh), palladium (Pd), osmium (Os), or iridium (Ir), or an alloy material or a compound material containing the above-described element as its main component. The peeling layer 702 can be formed by a sputtering method, various CVD methods such as a plasma CVD method, or the like, using these materials. As the stacked layer structure of a metal film and a metal oxide film, after such a metal film is formed, an oxide or oxynitride of the metal film can be formed on the metal film surface by performing plasma treatment in an oxygen atmosphere or an $N_2O$ atmosphere, or heat treatment in an oxygen atmosphere or an $N_2O$ atmosphere. For example, when a tungsten film is formed by a sputtering method, a CVD method, or the like as the metal film, a metal oxide film of tungsten oxide can be formed on the tungsten film surface by performing plasma treatment on the tungsten film. In this case, an oxide of tungsten is expressed by $WO_x$, and x is 2 to 3. There are cases of x=2 ($WO_2$), x=2.5 ($W_2O_5$),

x=2.75 ($W_4O_{11}$), x=3 ($WO_3$), and the like. When an oxide of tungsten is formed, the value "x" is not particularly restricted, and which oxide is to be formed may be decided based on an etching rate or the like. Alternatively, for example, a metal film (such as tungsten) is formed and then an insulating film of silicon oxide ($SiO_2$) or the like is formed over the metal film by a sputtering method, and a metal oxide may be formed on the metal film (for example, tungsten oxide on tungsten). In addition, as the plasma treatment, the above-described high-density plasma treatment may be performed, for example. In addition, other than the metal oxide film, a metal nitride or a metal oxynitride may also be used. In this case, the metal film may be subjected to plasma treatment or heat treatment in a nitrogen atmosphere or an atmosphere of nitrogen and oxygen.

As the insulating film 703, a single layer or stacked layers of a film containing an oxide of silicon or a nitride of silicon is/are formed by a sputtering method, a plasma CVD method, or the like. When the base insulating film employs a two-layer structure, a silicon nitride oxide film may be formed as a first layer, and a silicon oxynitride film may be formed as a second layer, for example. When the base insulating film employs a three-layer structure, a silicon oxide film, a silicon nitride oxide film, and a silicon oxynitride film may be formed as a first insulating film, a second insulating film, and a third insulating film, respectively. Alternatively, a silicon oxynitride film, a silicon nitride oxide film, and a silicon oxynitride film may be formed as a first insulating film, a second insulating film, and a third insulating film, respectively. The base insulating film functions as a blocking film for avoiding the entry of impurities from the substrate 701.

The amorphous semiconductor film 704 is formed with a thickness of 25 to 200 nm (preferably 30 to 150 nm) by a sputtering method, an LPCVD method, a plasma CVD method, or the like.

Next, the amorphous semiconductor film 704 is crystallized by laser irradiation. The amorphous semiconductor film 704 may be crystallized by a method or the like in which a laser irradiation method is combined with a thermal crystallization method using an RTA or an annealing furnace or a thermal crystallization method using a metal element for promoting crystallization. Then, the obtained crystalline semiconductor film is etched so as to have a desired shape; thereby forming crystalline semiconductor films 704a to 704d. Then, a gate insulating film 705 is formed so as to cover the crystalline semiconductor films 704a to 704d (FIG 4B).

An example of a manufacturing process of the crystalline semiconductor films 704a to 704d will be briefly described below. First, an amorphous semiconductor film with a thickness of 50 to 60 nm is formed by a plasma CVD method. Next, a solution containing nickel that is a metal element for promoting crystallization is retained on the amorphous semiconductor film, and dehydrogenation treatment (at 500 °C, for one hour) and thermal crystallization treatment (at 550 °C, for four hours) are performed on the amorphous semiconductor film; thereby forming a crystalline semiconductor film. After that, the crystalline semiconductor film is irradiated with laser light and subjected to a photolithography process, so that the crystalline semiconductor films 704a to 704d are formed. Without conducting the thermal crystallization which uses the metal element for promoting crystallization, the amorphous semiconductor film may be crystallized only by laser irradiation.

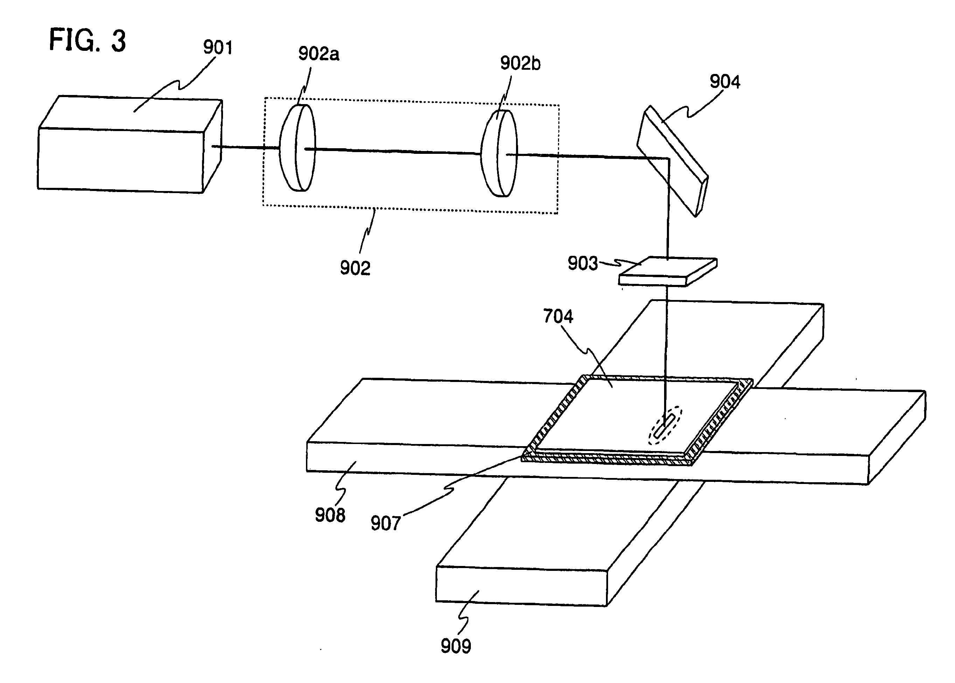

An example of a laser irradiation apparatus and a laser irradiation method used in laser irradiation will now be described (FIG. 3). The laser irradiation apparatus illustrated in FIG 3 includes a laser oscillator 901, a beam expander optical system 902 including a convex lens 902a and a convex lens 902b, a diffractive optical element 903, a mirror 904, a suction stage 907, an X stage 908, and a Y stage 909.

First, a substrate 701 provided with an amorphous semiconductor film 704 is prepared. The substrate 701 is fixed on the suction stage 907. The suction stage 907 can be moved freely in an X-axis direction and a Y-axis direction by using the X stage 908 and the Y stage 909. Note that the movement in the X-axis direction and the Y-axis direction can be performed by using various stages such as a motor stage, a ball bearing stage, or a linear motor stage.

Laser light emitted from the laser oscillator 901 enters the beam expander optical system 902, and then the scale of the laser light is processed to be larger by the beam expander optical system 902. After the laser light passes through the diffractive optical element 903 via the mirror 904, the amorphous semiconductor film 704 provided over the substrate 701 is irradiated with the laser light.

As the laser oscillator 901, a continuous wave laser (a CW laser) or a pulsed wave laser (a pulsed laser) can be used. As a laser beam which can be used here, a laser beam emitted from one or more of the following can be used: a gas laser such as an Ar laser, a Kr laser, or an excimer laser; a laser of which the medium is single crystalline YAG, $YVO_4$, forsterite ($Mg_2SiO_4$), $YAlO_3$, $GdVO_4$, or polycrystalline (ceramic) YAG, $Y_2O_3$, $YVO_4$, YLF, $YAlO_3$, $GdVO_4$, each added with one or more of Nd, Yb, Cr, Ti, Ho, Er, Tm, and Ta as a dopant; a glass laser; a ruby laser; an alexandrite laser; a Ti:sapphire laser; a copper vapor laser; or a gold vapor laser. It is possible to obtain crystals with a large grain size when fundamental waves of such laser beams or second to fourth harmonics of the fundamental waves are used. For example, the second harmonic (532 nm) or the third harmonic (355 nm) of an Nd:YVO$_4$ laser (fundamental wave of 1064 nm) can be used. In this case, an energy density of about 0.01 to 100 MW/cm$^2$ (preferably, 0.1 to 10 MW/cm$^2$) is required. Irradiation is conducted with a scanning rate of about 10 to 2000 cm/sec. It is to be noted that, a laser using, as a medium, single crystalline YAG, $YVO_4$, forsterite ($Mg_2SiO_4$), $YAlO_3$, or $GdVO_4$ or polycrystalline (ceramic) YAG, $Y_2O_3$, $YVO_4$, $YAlO_3$, or

$GdVO_4$ added with one or more of Nd, Yb, Cr, Ti, Ho, Er, Tm, and Ta as a dopant; an Ar ion laser; or a Ti:sapphire laser can be continuously oscillated. Furthermore, pulse oscillation thereof can be performed with a repetition rate of 10 MHz or more by carrying out Q switch operation, mode locking, or the like. In the case where a laser beam is oscillated with a repetition rate of 10 MHz or more, while a semiconductor film is melted by a laser beam and then solidified, the semiconductor film is irradiated with a next pulsed laser. Therefore, unlike the case of using a pulsed laser with a low repetition rate, a solid-liquid interface can be continuously moved in the semiconductor film, so that crystal grains which are continuously grown in the scanning direction can be obtained.

The laser oscillator 901, the convex lens 902a, and the convex lens 902b are arranged so as to satisfy the relationship described in Embodiment Mode 2. By employing such arrangement described in Embodiment Mode 2, positional displacement of the laser light which enters the convex lens 902b due to the change of emission angle of the laser light is reduced, and the displacement of entrance position into the diffractive optical element 903 can be reduced. Accordingly, the amorphous semiconductor film 704 can be irradiated with laser light having desired performance by using the laser irradiation apparatus described in this embodiment mode.

As a typical example of the diffractive optical element 903, a holographic optical element, a binary optical element, and the like are given. The diffractive optical element 903 is also called a diffractive optics or a diffractive optic element, and an element which can obtain a spectrum using optical diffraction. A diffractive optical element having a condenser lens function by being formed with a plurality of grooves on its surface can be used as the diffractive optical element 903. Then, by using this diffractive optical element 903, the laser light emitted from the laser oscillator can be formed into a linear or rectangular beam with a uniform energy distribution.

A condensing lens may be provided on the irradiation side of the diffractive optical element 903. For example, two cylindrical lenses can be used. In this case, laser light is made to perpendicularly enter the two cylindrical lenses. Since a cylindrical lens has a curvature in one direction, it is possible to condense or expand laser light only in a one-dimensional direction. Accordingly, by making the direction of a curvature of one of the two cylindrical lenses in an X-axis direction and making the direction of a curvature of the other of the two cylindrical lenses in a Y-axis direction, the size of a beam spot on an irradiation surface can be arbitrary changed in X and Y directions; accordingly, optical adjustment is easy and the degree of freedom of the adjustment is high. Alternatively, only in one direction the condensing or expanding of laser light may be performed by using one cylindrical lens. Further, in the case where condensing is performed while keeping a length ratio of a major axis and a minor axis of an image formed by the diffractive optical element 903, a spherical lens may be used instead of the cylindrical lens. Further, a slit optical system may be arranged instead of the diffractive optical element. The use of the slit optical system can conduct laser irradiation, after opposite end portions of a linear or rectangular laser beam, whose energy is not sufficient, is cut. Therefore, a semiconductor film can be crystallized favorably.

Note that in the laser irradiation apparatus illustrated in FIG 3, the optical length between the emission point of the laser oscillator 901 and the lens 902b is preferably one meter or more, in terms of the structure of the apparatus. Even when an optical length of one meter or more is adopted, laser light can enter a desired entrance point of the diffractive optical element. Thus, the amorphous semiconductor film 704 can be irradiated with the laser light having desired characteristics.

By the above-described laser irradiation method in this manner, the amorphous semiconductor film 704 can be crystallized uniformly.

Next, the gate insulating film 705 covering the crystalline semiconductor films 704a to 704d is formed. As the gate insulating film 705, a single layer or stacked layers of a film containing an oxide of silicon or a nitride of silicon is/are formed by a CVD method, a sputtering method, or the like. Specifically, a film containing silicon oxide, a film containing silicon oxynitride, or a film containing silicon nitride oxide is formed in a single layer or stacked layers.

Alternatively, the above-described high-density plasma treatment on the semiconductor films 704a to 704d may be conducted to oxidize or nitride the surfaces to form the gate insulating film 705. For example, the film is formed by plasma treatment introducing a mixed gas of a rare gas such as He, Ar, Kr, or Xe and oxygen, nitrogen oxide ($NO_2$), ammonia, nitrogen, hydrogen, or the like. When excitation of the plasma in this case is performed by introduction of a microwave, high density plasma with a low electron temperature can be generated. By oxygen radicals (or OH radicals in some cases) or nitrogen radicals (or NH radicals in some cases) generated by this high-density plasma, the surface of the semiconductor film can be oxidized or nitrided.

By such treatment using high-density plasma, an insulating film with a thickness of 1 to 20 nm, typically 5 to 10 nm, is formed on a semiconductor film. Since the reaction in this case is a solid-phase reaction, the interface state density between the insulating film and the semiconductor film can be extremely low. Since such high-density plasma treatment oxidizes (or nitrides) a semiconductor film (crystalline silicon, or polycrystalline silicon) directly, the thickness of the insulating film to be formed can be almost even, ideally. In addition, oxidation is not strengthened even at a crystal grain boundary of crystalline silicon, which makes a very preferable condition. That is, by a solid-phase oxidation of the surface of the semiconductor film by the high-density plasma treatment shown here, the insulating film with good uniformity and low interface state density can be formed without causing oxidation reaction abnormally at a crystal grain boundary.

As the gate insulating film, only an insulating film formed by the high-density plasma treatment may be used, or an insulating film of silicon oxide, silicon oxynitride, silicon nitride, or the like may be formed thereover by a CVD method using plasma or thermal reaction, so as to make stacked layers. In either case, a transistor including an insulating film formed by high-density plasma, in a part of the gate insulating film or in the whole gate insulating film, can reduce unevenness of the transistor characteristics.

Furthermore, the semiconductor films 704a to 704d crystallized by irradiating a semiconductor film with a continuous wave laser beam or a laser beam oscillated with a repetition rate of 10 MHz or more and scanning the semiconductor film in one direction, have crystals grown in the scanning direction of the beam. When a transistor is formed so that the scanning direction is aligned with the channel length direction (the direction in which carriers flow when a channel formation region is formed) and the above-described gate insulating layer is used, a thin film transistor (TFT) with almost no characteristic variation and high field-effect mobility can be obtained.

Next, a first conductive film and a second conductive film are stacked over the gate insulating film 705. Here, the first conductive film is formed with a thickness of 20 to 100 nm and the second conductive film is formed with a thickness of 100 to 400 nm, by a plasma CVD method, a sputtering method, or the like. The first conductive film and the second conductive film are formed using an element selected from tantalum (Ta), tungsten (W), titanium (Ti), molybdenum (Mo), aluminum (Al), copper (Cu), chromium (Cr), niobium (Nb), or the like, or an alloy material or a compound material containing such an element as its main component. Alternatively, the first and second conductive films are formed using a semiconductor material typified by polycrystalline silicon doped with an impurity element such as phosphorus. As examples of a combination of the first conductive film and the second conductive film, a tantalum nitride film and a tungsten film, a tungsten nitride film and a tungsten film, a molybdenum nitride film and a molybdenum film, and the like can be given. Since tungsten and tantalum nitride have high heat resistance, heat treatment for thermal activation can be performed after the first conductive film and the second conductive film are formed. In addition, in a case of a three-layer structure instead of a two-layer structure, a stacked layer structure of a molybdenum film, an aluminum film, and a molybdenum film may be adopted.

Next, a resist mask is formed by a photolithography method, and etching treatment for forming a gate electrode and a gate line is performed, so that gate electrodes 707 are formed above the semiconductor films 704a to 704d.

Next, a resist mask is formed by a photolithography method, and the crystalline semiconductor films 704a to 704d are doped with an impurity element imparting n-type conductivity with a low concentration by an ion doping method or an ion implantation method. As the impurity element imparting n-type conductivity, an element which belongs to Group 15 may be used; for example, phosphorus (P) or arsenic (As) is used.

Next, an insulating film is formed so as to cover the gate insulating film 705 and the gate electrodes 707. The insulating film is formed as a single layer or stacked layers of a film containing an inorganic material such as silicon, an oxide of silicon, or a nitride of silicon, or an organic material such as an organic resin, by a plasma CVD method, a sputtering method, or the like. Next, the insulating film is selectively etched by anisotropic etching which is done mainly in a vertical direction, so that insulating films 708 (also referred to as side walls) which are in contact with side surfaces of the gate electrodes 707 are formed. The insulating films 708 are used as masks for doping when LDD (Lightly Doped drain) regions are formed later.

Next, using a resist mask formed by a photolithography method, the gate electrodes 707, and the insulating films 708 as masks, an impurity element imparting n-type conductivity is added to the crystalline semiconductor films 704a to 704d, so that first n-type impurity regions 706a (also referred to as LDD regions), second n-type impurity regions 706b, and channel regions 706c are formed (FIG. 4C). The concentration of the impurity element contained in the first n-type impurity regions 706a is lower than the concentration of the impurity element contained in the second n-type impurity regions 706b.

Next, an insulating film is formed as a single layer or stacked layers so as to cover the gate electrodes 707, the insulating films 708, and the like; thereby forming thin film transistors 730a to 730d (FIG 4D). The insulating film is formed in a single layer or stacked layers using an inorganic material such as an oxide of silicon or a nitride of silicon, an organic material such as polyimide, polyamide, benzocyclobutene, acrylic, or epoxy, a siloxane material, or the like, by a CVD method, a sputtering method, an SOG method, a droplet discharge method, a screen printing method, or the like. For example, when the insulating film has a two-layer structure, a silicon nitride oxide film may be formed as a first insulating film 709, and a silicon oxynitride film may be formed as a second insulating film 710.

In addition, before the insulating films 709 and 710 are formed or after one or both of the insulating films 709 and 710 are formed, heat treatment for recovering the crystallinity of the semiconductor film, for activating the impurity element which has been added into the semiconductor film, or for hydrogenating the semiconductor film may be performed. For the heat treatment, thermal annealing, a laser annealing method, an RTA method, or the like may be adopted.

Next, the insulating films 709 and 710, or the like are etched by a photolithography method, and contact holes are formed to expose the second n-type impurity regions 706b. Then, a conductive film is formed so as to fill the contact holes and the conductive film is selectively etched so as to form conductive films 731. Alternatively, before forming the conductive film, silicides may be formed on the surfaces of the semiconductor films 704a to 704d exposed at the contact holes.

The conductive film 731 is formed in a single layer or stacked layers using an element selected from aluminum (Al), tungsten (W), titanium (Ti), tantalum (Ta), molybdenum (Mo), nickel (Ni), platinum (Pt), copper (Cu), gold (Au), silver (Ag), manganese (Mn), neodymium (Nd), carbon (C), or silicon (Si), or an alloy material or a compound material containing such an element as its main component by a CVD method, a sputtering method, or the like. An alloy material containing aluminum as its main component corresponds to a material which contains aluminum as its main component and also contains nickel or an alloy material which contains aluminum as its main component and which also contains nickel and one or both of carbon and silicon, for example. The conductive film 731 preferably employs, for example, a stacked layer structure of a barrier film, an aluminum-silicon (Al-Si) film, and a barrier film, or a stacked layer structure of a barrier film, an aluminum-silicon (Al-Si) film, a titanium nitride (TiN) film, and a barrier film. It is to be noted that a barrier film corresponds to a thin film formed of titanium, a nitride of titanium, molybdenum, or a nitride of molybdenum. Aluminum and aluminum silicon which have low resistance and are inexpensive are optimal materials for forming the conductive film 731. In addition, generation of a hillock of aluminum or aluminum silicon can be prevented when upper and lower barrier layers are formed. Furthermore, when the barrier film is formed of titanium that is a highly-reducible element, even if a thin natural oxide film is formed on the crystalline semiconductor film, the natural oxide film is reduced so that preferable contact with the crystalline semiconductor film can be obtained.

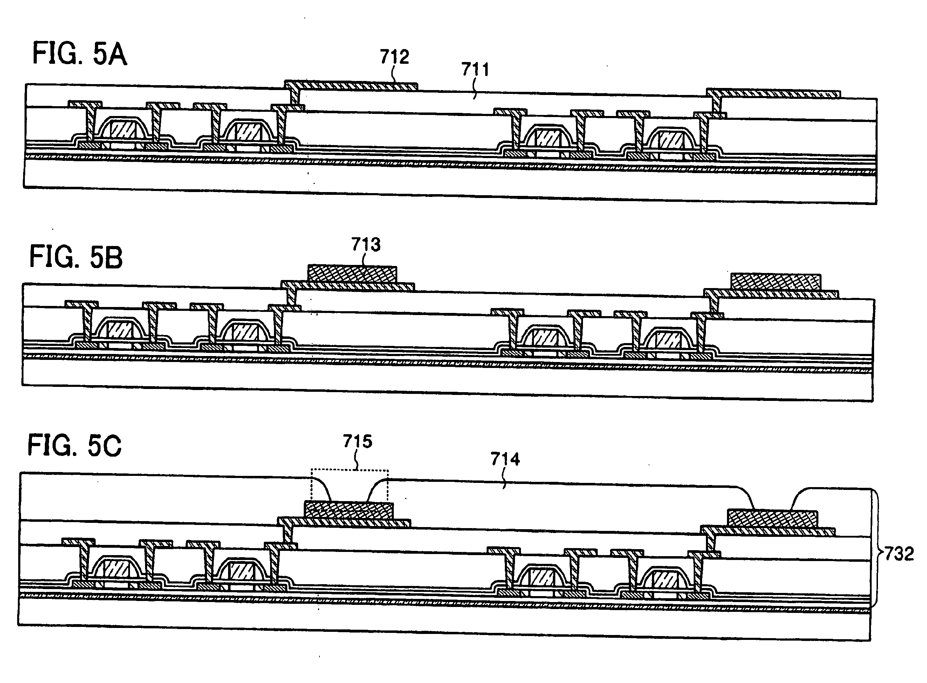

Next, an insulating film 711 is formed so as to cover the conductive films 731, and conductive films 712 are formed over the insulating film 711 so as to be electrically connected to the conductive films 731 (FIG. 5A). The insulating film 711 is formed in a single layer or stacked layers using an inorganic material or an organic material by a CVD method, a sputtering method, an SOG method, a droplet discharge method, a screen printing method, or the like. The insulating film 711 is preferably formed with a thickness of 0.75 to 3 $\mu$m. Furthermore, the conductive films 712 can be formed using any of the materials given for the conductive films 731.

Next, conductive films 713 are formed over the conductive films 712. The conductive films 713 are formed using a conductive material, by a CVD method, a sputtering method, a droplet discharge method, a screen printing method, or the like (FIG. 5B). Preferably, the conductive films 713 are formed in a single layer or stacked layers using an element selected from aluminum (Al), titanium (Ti), silver (Ag), copper (Cu), or gold (Au), or an alloy material or a compound material containing such an element as its main component. Here, a paste containing silver is formed over the conductive films 712 by a screen printing method, and then, heat treatment at 50 to 350 °C is performed; thereby forming the conductive films 713. In addition, after the conductive films 713 are formed over the conductive films 712, regions where the conductive films 713 and the conductive films 712 overlap each other may be irradiated with laser light so as to improve electrical connection thereof. Alternatively, it is possible to selectively form the conductive films 713 over the conductive films 731 without forming the insulating film 711 and the conductive films 712.

Next, an insulating film 714 is formed so as to cover the conductive films 712 and 713, and the insulating film 714 is selectively etched by a photolithography method; thereby forming opening portions 715 to expose the conductive films 713 (FIG 5C). The insulating film 714 is formed in a single layer or stacked layers using an inorganic material or an organic material, by a CVD method, a sputtering method, an SOG method, a droplet discharge method, a screen printing method, or the like.

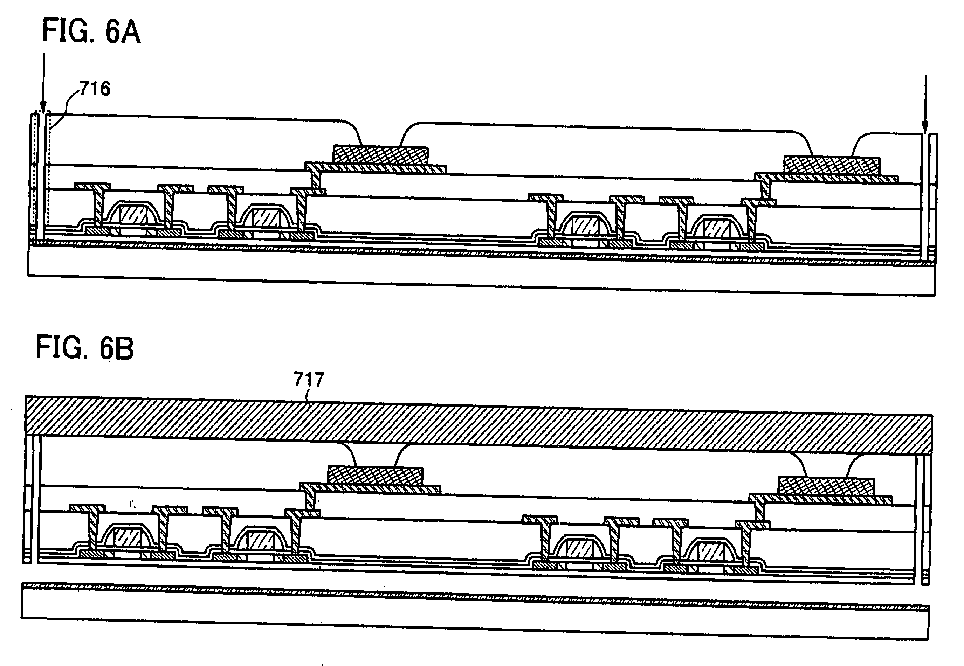

Next, a layer 732 including the thin film transistors 730a to 730d and the like (hereinafter also referred to as a "layer 732") is peeled from the substrate 701. Here, opening portions 716 are formed by laser irradiation (such as UV light) (FIG. 6A), and then, the layer 732 can be peeled from the substrate 701 by physical force. Alternatively, an etchant may be introduced to the opening portions 716 before peeling the layer 732 from the substrate 701; thereby removing the peeling layer 702. As the etchant, a gas or a liquid containing halogen fluoride or an interhalogen compound is used; for example, chlorine trifluoride ($ClF_3$) is used as a gas containing halogen fluoride. Accordingly, the layer 732 is peeled from the substrate 701. The peeling layer 702 may be partially left instead of being removed completely; accordingly, consumption of the etchant can be reduced and process time for removing the peeling layer can be shortened. In addition, the layer 732 can be retained on the substrate 701 even after the peeling layer 702 is removed. In addition, it is preferable to reuse the substrate 701 after the layer 732 is peeled off, in order to reduce the cost.

Here, after the opening portions 716 are formed by etching the insulating films by laser irradiation, a surface of the layer 732 (a surface where the insulating film 714 is exposed) is attached to a first sheet material 717 and the layer 732 is peeled completely from the substrate 701 (FIG 6B). As the first sheet material 717, a thermal peeling tape of which adhesiveness is lowered by heat can be used, for example.

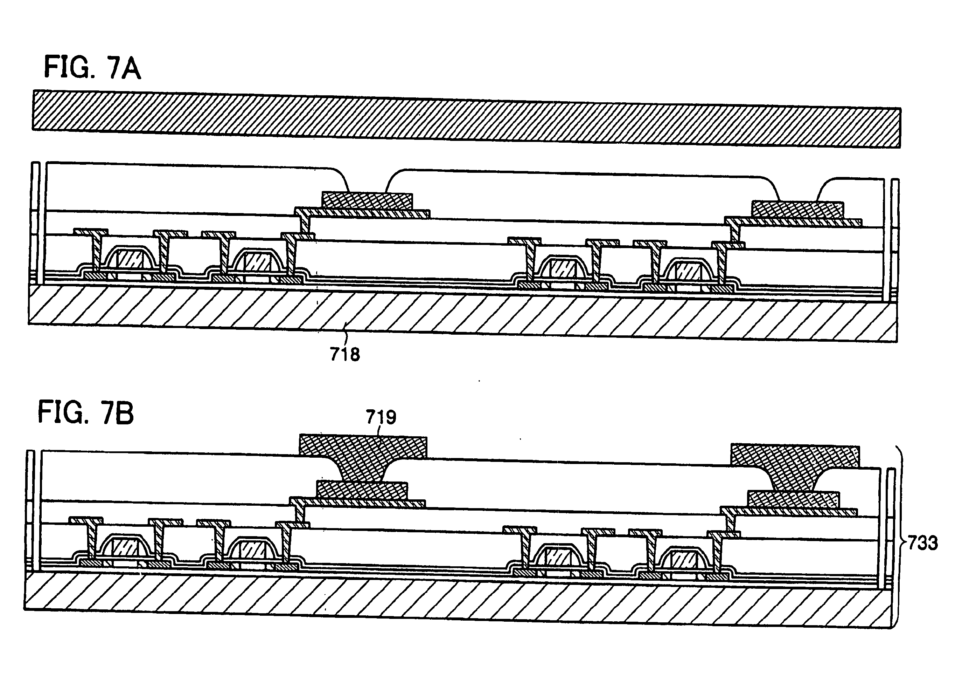

Next, a second sheet material 718 is provided over the other surface (the surface peeled from the substrate 701) of the layer 732, and one or both of heat treatment and pressure treatment is/are performed to attach the second sheet material 718. Concurrently with or after providing the second sheet material 718, the first sheet material 717 is peeled (FIG 7A). As the second sheet material 718, a hot-melt film or the like can be used. When a thermal peeling tape is used as the first sheet material 717, the peeling can be performed by using the heat applied for attaching the second sheet material 718.

As the second sheet material 718, a film subjected to antistatic treatment for preventing static electricity or the like (hereinafter referred to as an antistatic film) may be used. As the antistatic film, a film with an antistatic material dispersed in a resin, a film with an antistatic material attached thereon, and the like can be given as examples. The film provided with an antistatic material may be a film with an antistatic material provided over one of its surfaces, or a film with an antistatic material provided over both of its surfaces. As for the film with an antistatic material provided over one of its surfaces, the film may be attached to the layer 732 such that the surface provided with the antistatic material faces inside or outside. The antistatic material may be provided over the entire surface of the film, or over a part of the film. As the antistatic material here, a metal, indium tin oxide (ITO), a surfactant such as an amphoteric surfactant, a cationic surfactant, or a nonionic surfactant can be used. In addition to that, as the antistatic material, a resin material containing crosslinkable copolymer having a carboxyl group and a quaternary ammonium base on its side chain, or the like can be used. By attaching, mixing, or applying such a material to a film, an antistatic film can be formed. By sealing a semiconductor element with the antistatic film, adverse effects on the semiconductor element, when the semiconductor element is dealt with as a commercial product, due to static electricity or the like from outside can be suppressed.

Next, conductive films 719 are formed so as to cover the opening portions 715, and accordingly, an element group 733 is formed (FIG. 7B). It is to be noted that, before or after the formation of the conductive films 719, the conductive films 712 and 713 may be irradiated with laser light so as to improve electrical connection thereof.

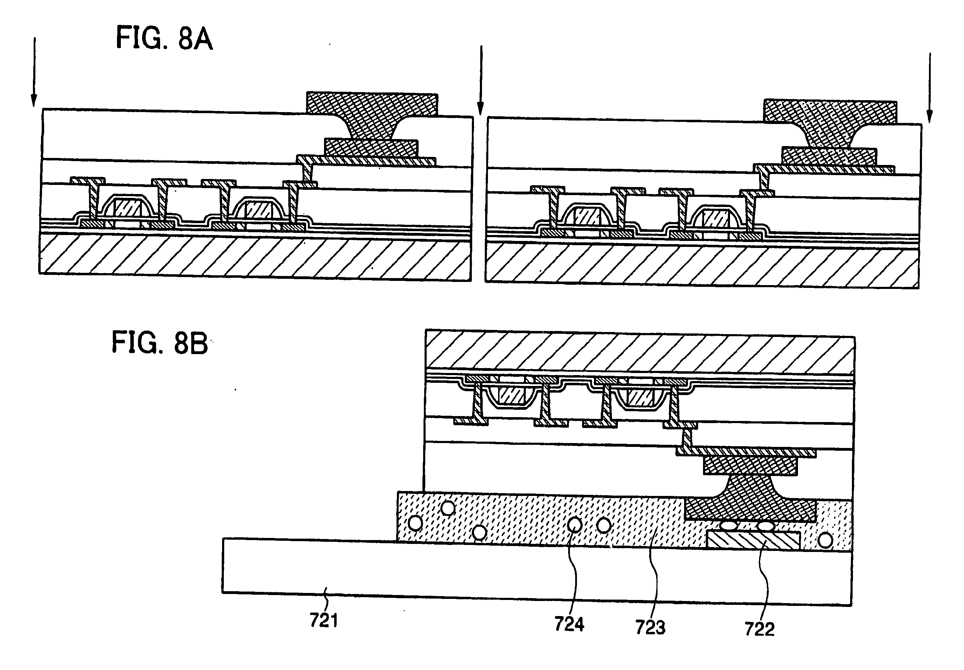

Next, the element group 733 is selectively irradiated with laser light so as to be divided into a plurality of element groups (FIG 8A).

Next, the element group 733 is pressure-bonded to a substrate 721 over which a conductive film 722 functioning as an antenna is formed (FIG. 8B). Specifically, the element group 733 is attached to the substrate 721 so that the conductive film 722 functioning as an antenna formed over the substrate 721 and the conductive film 719 of the element group 733 are electrically connected to each other. Here, the substrate 721 and the element group 733 are bonded to each other by using a resin 723 having adhesiveness. In addition, the conductive film 722 and the conductive film 719 are electrically connected to each other by using a conductive particle 724 contained in the resin 723.

By using the manufacturing method described in this embodiment mode, a highly reliable semiconductor device without variations in its properties can be manufactured.

This embodiment mode can be freely combined with the above embodiment modes. In other words, the material or the formation method described in the above embodiment modes can be used in combination also in this embodiment mode, and the material or the formation method described in this embodiment mode can be used in combination also in the above embodiment modes.

Embodiment Mode 4

Embodiment Mode 4 will describe an example of usage modes of the semiconductor device which is obtained by the manufacturing method described in Embodiment Mode 3. Specifically, applications of a semiconductor device which can input and output data without contact (or wirelessly) will be described below with reference to drawings. The semiconductor device which can input and output data without contact is also referred to as an RFID tag, an ID tag, an IC tag, an IC chip, an RF tag, a wireless tag, an electronic tag, or a wireless chip depending on application modes.

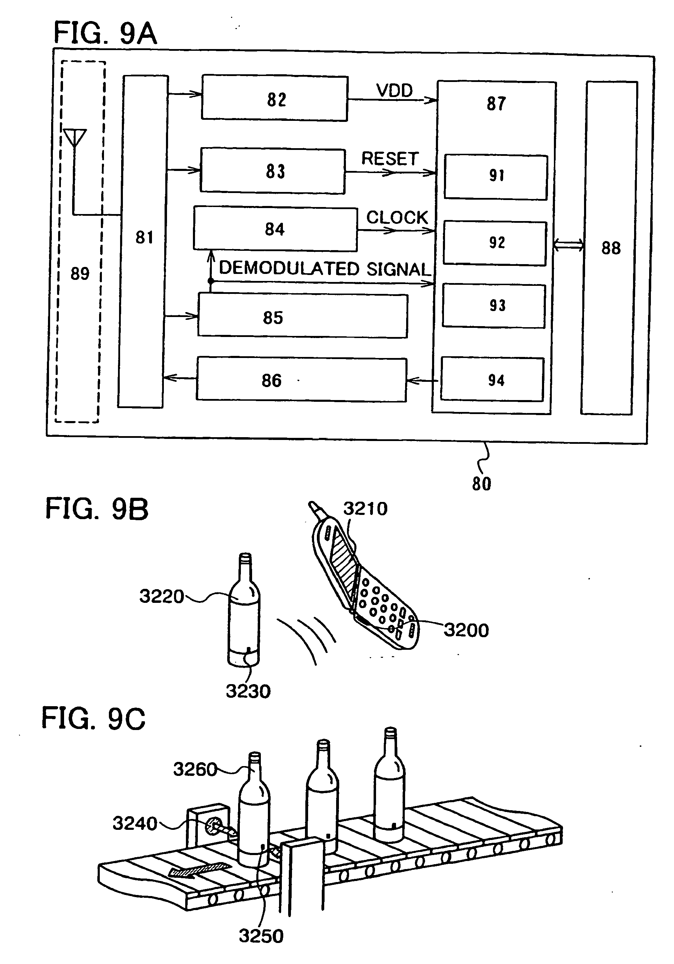

A semiconductor device 80 has a function of communicating data without contact (or wirelessly), and includes a high frequency circuit 81, a power supply circuit 82, a reset circuit 83, a clock generation circuit 84, a data demodulation circuit 85, a data modulation circuit 86, a control circuit 87 for controlling other circuits, a memory circuit 88, and an antenna 89 (FIG 9A). The high frequency circuit 81 is a circuit which receives a signal from the antenna 89 and makes the antenna 89 output a signal received from the data modulation circuit 86. The power supply circuit 82 is a circuit which generates a power supply potential from the received signal. The reset circuit 83 is a circuit which generates a reset signal. The clock generation circuit 84 is a circuit which generates various clock signals based on the received signal input from the antenna 89. The data demodulation circuit 85 is a circuit which demodulates the received signal and outputs the signal to the control circuit 87. The data modulation circuit 86 is a circuit which modulates a signal received from the control circuit 87. As the control circuit 87, a code extraction circuit 91, a code determination circuit 92, a CRC determination circuit 93, and an output unit circuit 94 are formed, for example. In addition, the code extraction circuit 91 is a circuit which individually extracts a plurality of codes included in an instruction transmitted to the control circuit 87. The code determination circuit 92 is a circuit which compares the extracted code and a reference code to determine the content of the instruction. The CRC determination circuit 93 is a circuit which detects the presence or absence of a transmission error or the like based on the determined code.

Next, an example of operation of the above-described semiconductor device will be explained. First, a radio signal is received by the antenna 89. The radio signal is transmitted to the power supply circuit 82 via the high frequency circuit 81, and a high power supply potential (hereinafter referred to as VDD) is generated. The VDD is supplied to the circuits included in the semiconductor device 80. In addition, a signal transmitted to the data demodulation circuit 85 via the high frequency circuit 81 is demodulated (hereinafter, a demodulated signal). Furthermore, a signal transmitted through the reset circuit 83 and the clock generation circuit 84 via the high frequency circuit 81 and the demodulated signal are transmitted to the control circuit 87. The signals transmitted to the control circuit 87 are analyzed by the code extraction circuit 91, the code determination circuit 92, the CRC determination circuit 93, or the like. Then, in accordance with the analyzed signals, information of the semiconductor device stored in the storage circuit 88 is output. The output information of the semiconductor device is encoded through the output unit circuit 94. Furthermore, the encoded information of the semiconductor device 80 is, via the data modulation circuit 86, transmitted by the antenna 89 as a radio signal. It is to be noted that a low power supply potential (hereinafter, VSS) can be common among a plurality of circuits included in the semiconductor device 80, and VSS can be GND.

Thus, data of the semiconductor device 80 can be read by transmitting a signal from a reader/writer to the semiconductor device 80 and receiving the signal transmitted from the semiconductor device 80 by the reader/writer.

In addition, the semiconductor device 80 may supply power to each circuit by an electromagnetic wave without a power source (battery) mounted, or by an electromagnetic wave and a power source (battery) with the power source (battery) mounted.

Since a semiconductor device which is bendable can be manufactured by using the manufacturing method described in the above embodiment mode, the semiconductor device can be attached to an object having a curved surface. By using the manufacturing method described in the above embodiment mode, a highly reliable semiconductor device without variations in its properties can be manufactured.

Next, an example of usage modes of a flexible semiconductor device which can input and output data without contact (wirelessly) will be explained. A side face of a portable terminal including a display portion 3210 is provided with a reader/writer 3200, and a side face of an article 3220 is provided with a semiconductor device 3230 (FIG. 9B). When the reader/writer 3200 is held over the semiconductor device 3230 included in the article 3220, information on the article 3220 such as a raw material, the place of origin, an inspection result in each production step, the history of distribution, or an explanation of the article is displayed on the display portion 3210. Furthermore, when a product 3260 is transported by a conveyor belt, the product 3260 can be inspected using a reader/writer 3240 and a semiconductor device 3250 attached to the product 3260 (FIG 9C). Thus, by utilizing the semiconductor device in systems, information can be acquired easily, and improvement in functionality and added value of the systems can be achieved. A transistor or the like included in a semiconductor device can be prevented from being damaged even when the semiconductor device is attached to an object having a curved surface as described above, and a highly reliable semiconductor device can be provided.

In addition, as a signal transmission method in the above-described semiconductor device which can input and output data without contact (or wirelessly), an electromagnetic coupling method, an electromagnetic induction method, a microwave method, or the like can be adopted. The transmission method may be appropriately selected by a practitioner in consideration of an intended use, and an optimum antenna may be provided in accordance with the transmission method.

In a case of adopting, for example, an electromagnetic coupling method or an electromagnetic induction method (for example, 13.56 MHz band) as the signal transmission method in the semiconductor device, electromagnetic induction caused by a change in magnetic field density is used. Therefore, the conductive film functioning as an antenna is formed in an annular shape (for example, a loop antenna) or a spiral shape (for example, a spiral antenna).

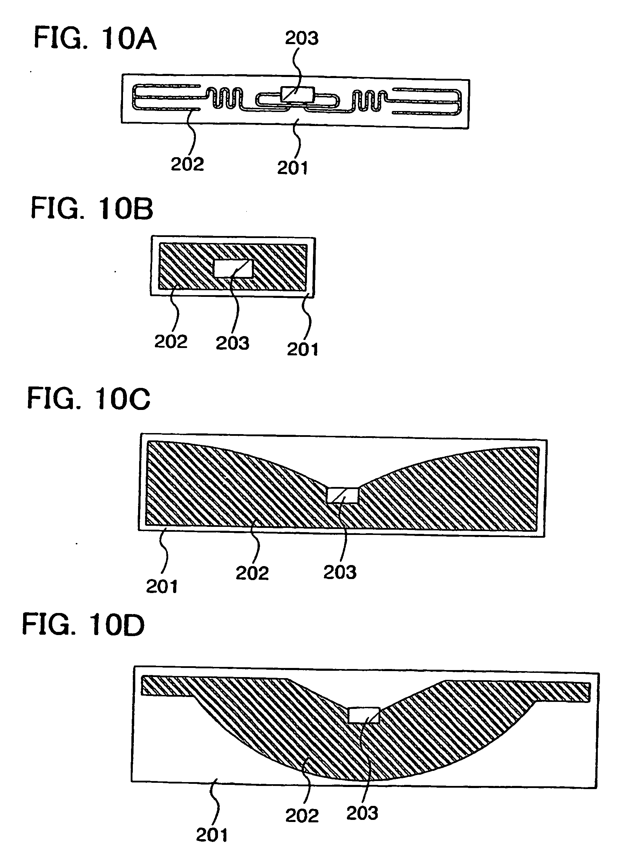

In a case of adopting a microwave method (for example, a UHF band (860 to 960 MHz band), a 2.45 GHz band, or the like) as the signal transmission method in the semiconductor device, the shape such as a length of the conductive film functioning as an antenna may be appropriately set in consideration of a wavelength of an electromagnetic wave used for signal transmission. For example, a conductive film 202 functioning as an antenna is formed over a substrate 201 in a linear shape (for example, a dipole antenna (FIG 10A)), a flat shape (for example, a patch antenna (FIG 10B)), a ribbon-like shape (FIGS. 10C and 10D), or the like, and then a semiconductor device 203 is provided so as to be electrically connected to the conductive film 202 functioning as an antenna. The shape of the conductive film 202 functioning as an antenna is not limited to a linear shape, and the conductive film 202 functioning as an antenna may be formed in a curved-line shape, a meander shape, or a combination thereof, in consideration of a wavelength of an electromagnetic wave. Whichever shape the conductive film 202 functioning as an antenna has, an element group or the like can be prevented from being broken by controlling the pressure applied to the element group while monitoring the pressure so as not to give excessive pressure to the element group, in attachment of the element group as described in the above embodiment mode.

The conductive film functioning as an antenna is formed using a conductive material by a CVD method, a sputtering method, a printing method such as screen printing or gravure printing, a droplet discharge method, a dispenser method, a plating method, or the like. The conductive film is formed with a single-layer structure or a stacked layer structure using an element selected from aluminum (Al), titanium (Ti), silver (Ag), copper (Cu), gold (Au), platinum (Pt), nickel (Ni), palladium (Pd), tantalum (Ta), or molybdenum (Mo) or an alloy material or a compound material containing such an element as its main component.

In a case of forming a conductive film functioning as an antenna by, for example, a screen printing method, the conductive film can be formed by selectively printing a conductive paste in which conductive particles each having a grain size of several nm to several tens of $\mu$m are dissolved or dispersed in an organic resin. As the conductive particle, a fine particle, or a dispersive nanoparticle of one or more metals such as silver (Ag), gold (Au), copper (Cu), nickel (Ni), platinum (Pt), palladium (Pd), tantalum (Ta), molybdenum (Mo), and titanium (Ti) or silver halide can be used. In addition, as the organic resin contained in the conductive paste, one or a plurality of organic resins functioning as a binder, a solvent, a dispersant, or a coating of the metal particle can be used. Typically, an organic resin such as an epoxy resin can be used. In formation of the conductive film, baking is preferably performed after the conductive paste is applied. For example, in a case of using fine particles (of which grain size is 1 to 100 nm inclusive) containing silver as its main component as a material of the conductive paste, a conductive film can be obtained by hardening the conductive paste by baking at a temperature of 150 to 300 °C. Alternatively, fine particles containing solder or lead-free solder as its main component may be used; in this case, it is preferable to use fine particles having a grain size of 20 $\mu$m or less. Solder or lead-free solder has an advantage such as low cost.

Besides such materials, ceramic, ferrite, or the like may be applied to an antenna. Furthermore, a material of which dielectric constant and magnetic permeability are negative in a microwave band (metamaterial) can be applied to an antenna.

In a case of applying an electromagnetic coupling method or an electromagnetic induction method, and placing a semiconductor device including an antenna in contact with a metal, a magnetic material having magnetic permeability is preferably provided between the semiconductor device and the metal. In the case of placing a semiconductor device including an antenna in contact with a metal, an eddy current flows in the metal accompanying a change in a magnetic field, and a demagnetizing field generated by the eddy current impairs a change in a magnetic field and decreases a communication range. Therefore, an eddy current of the metal and a decrease in the communication range can be suppressed by providing a material having magnetic permeability between the semiconductor device and the metal. It is to be noted that ferrite or a metal thin film having high magnetic permeability and little loss of high frequency wave can be used as the magnetic material.

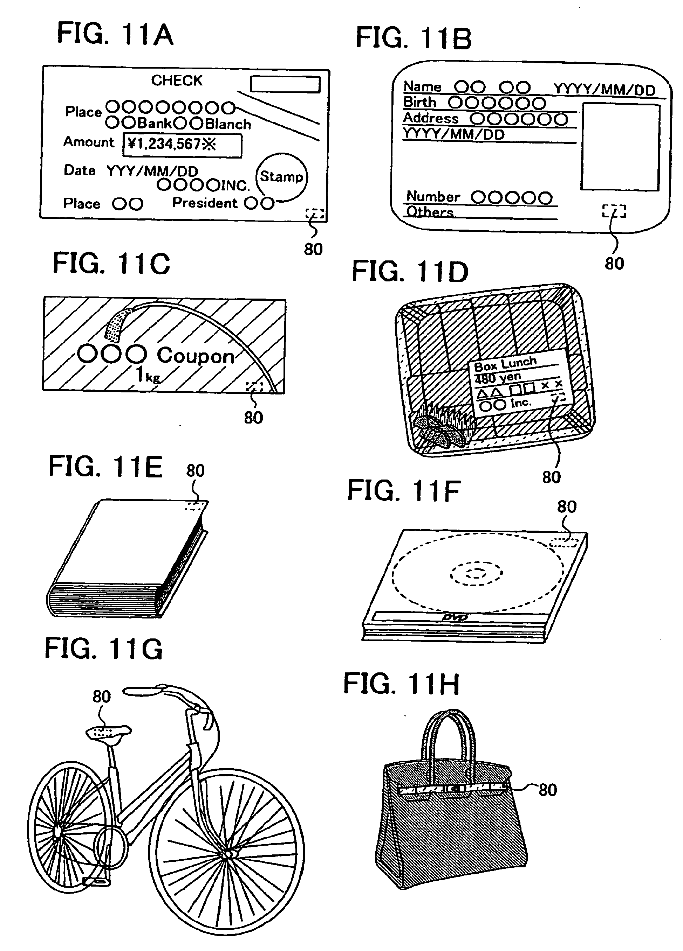

The applicable range of the semiconductor device is extremely wide, without being limited to the above examples, and the semiconductor device can be applied to any product, which can be a product whose production, management, or the like can be supported by clarifying information such as the history of the product without contact. For example, the semiconductor device can be mounted on paper money, coins, securities, certificates, bearer bonds, packing containers, books, recording media, personal belongings, vehicles, food, clothing, health products, commodities, medicines, electronic devices, and the like. Examples of them will be explained with reference to FIGS. 11A to 11H.

The paper money and coins are money distributed to the market, and include one valid in a certain area (cash voucher), memorial coins, and the like. The securities refer to checks, certificates, promissory notes, and the like (FIG. 11A). The certificates refer to driver's licenses, certificates of residence, and the like (FIG 11B). The bearer bonds refer to stamps, rice coupons, various gift certificates, and the like (FIG 11C). The packing containers refer to wrapping paper for food containers and the like, plastic bottles, and the like (FIG 11D). The books refer to hardbacks, paperbacks, and the like (FIG. 11E). The recording media refer to DVD software, video tapes, and the like (FIG 11F). The vehicles refer to wheeled vehicles such as bicycles, ships, and the like (FIG. 11G). The personal belongings refer to bags, glasses, and the like (FIG 11H). The food refers to food articles, drink, and the like. The clothing refers to clothes, footwear, and the like. The health products refer to medical instruments, health instruments, and the like. The commodities refer to furniture, lighting equipment, and the like. The medicine refers to medical products, pesticides, and the like. The electronic devices refer to liquid crystal display devices, EL display devices, television devices (TV sets, flat-screen TV sets), cellular phones, and the like.

Forgery can be prevented by providing the semiconductor device 80 shown in FIG 9A to the paper money, the coins, the securities, the certificates, the bearer bonds, or the like. The efficiency of an inspection system, a system used in a rental shop, or the like can be improved by providing the semiconductor device 80 to the packing containers, the books, the recording media, the personal belongings, the food, the commodities, the electronic devices, or the like. Forgery or theft can be prevented by providing the semiconductor device 80 to the vehicles, the health products, the medicine, or the like; further, in the case of the medicine, medicine can be prevented from being taken mistakenly. The semiconductor device 80 can be provided to such an article by being attached to the surface or being embedded therein. For example, in the case of a book, the semiconductor device 80 may be embedded in a piece of paper; in the case of a package made from an organic resin, the semiconductor device 80 may be embedded in the organic resin.

As described above, the efficiency of an inspection system, a system used in a rental shop, or the like can be improved by providing the semiconductor device to the packing containers, the recording media, the personal belonging, the food, the clothing, the commodities, the electronic devices, or the like. In addition, by providing the semiconductor device to the vehicles, forgery or theft can be prevented. Further, by implanting the semiconductor device in a creature such as an animal, an individual creature can be easily identified. For example, by implanting the semiconductor device with a sensor in a creature such as livestock, its health condition such as a current body temperature as well as its birth year, sex, breed, or the like can be easily managed.

It is to be noted that this embodiment mode can be freely combined with the above embodiment modes. In other words, the material or the formation method described in the above embodiment modes can be used in combination also in this embodiment mode, and the material or the formation method described in this embodiment mode can be used in combination also in the above embodiment modes.

## Claims

1. A laser irradiation apparatus comprising:

   a laser oscillator (101);
   a beam expander optical system (102) which receives laser light (105) emitted from the laser oscillator (101); and
   a diffractive optical element (103) which receives laser light (105) transmitted through the beam expander optical system (102),
   **characterised in that** the beam expander optical system (102) includes a first lens (102a) and a second lens (102b) in this order from a laser oscillator (101) side, and
   wherein equations $c = f_1$, $d = f_1 + f_2$, and $e = f_2$ are satisfied, where "c" is an optical length between an emission point of the laser oscillator (101) and the first lens (102a), "d" is an optical length between the first lens (102a) and the second lens (102b), "e" is an optical length between the second lens (102b) and the diffractive optical element (103), $f_1$ is a focal length of the first lens (102a), and $f_2$ is a focal length of the second lens (102b).

2. The laser irradiation apparatus according to claim 1, wherein an optical length between the emission point of the laser oscillator (101) and the second lens (102b) is one meter or longer.

3. The laser irradiation apparatus according to claim 1, wherein the first lens (1 02a) and the second lens (102b) are convex lenses.

4. A laser irradiation method comprising the steps of:

   emitting laser light (105) from a laser oscillator (101);

allowing the laser light (105) to enter a beam expander optical system (102); and

allowing the laser light (105) which have passed through the beam expander optical system (102) to enter a diffractive optical element (103), **characterised in that** the beam expander optical system (102) includes a first lens (102a) and a second lens (102b) in this order from a laser oscillator (101) side, and

wherein the laser oscillator (101), the first lens (102a), the second lens (102b), and the diffractive optical element (103) are arranged so that equations $c = f_1$, $d = f_1 + f_2$, and $e = f_2$ are satisfied, where "c" is an optical length between an emission point of the laser oscillator (101) and the first lens (102a), "d" is an optical length between the first lens (102a) and the second lens (102b), "e" is an optical length between the second lens (102b) and the diffractive optical element (103), $f_1$ is a focal length of the first lens (102a), and $f_2$ is a focal length of the second lens (102b).

5. The laser irradiation method according to claim 4, wherein an optical length between the emission point of the laser oscillator (101) and the second lens (102b) is one meter or longer.

6. The laser irradiation method according to claim 4, wherein the first lens (102a) and the second lens (102b) are convex lenses.

7. A method for manufacturing a semiconductor device, comprising the steps of:

forming a semiconductor film (704) over a substrate (701);

emitting laser light from a laser oscillator (101, 901); and

irradiating the semiconductor film (704) with the laser light through a beam expander optical system (102, 902) and a diffractive optical element (103, 903), by the method according to one of the claims 4 - 6.

**Patentansprüche**

1. Laserbestrahlungsgerät, das umfasst:

einen Laseroszillator (101);

ein optisches System (102) zur Strahlaufweitung, das Laserlicht (105) empfängt, das aus dem Laseroszillator (101) emittiert wird; und

ein beugendes optisches Element (103), das Laserlicht (105) empfängt, das sich durch das optische System (102) zur Strahlaufweitung durchlässt,

**dadurch gekennzeichnet, dass** das optische System (102) zur Strahlaufweitung eine erste Linse (102a) und eine zweite Linse (102b) in dieser Reihenfolge von einer Laseroszillator (101)-Seite aus aufweist, und

wobei Gleichungen $c = f_1$, $d = f_1 + f_2$ und $e = f_2$ erfüllt werden, wo "c" eine optische Länge zwischen einem Emissionspunkt des Laseroszillators (101) und der ersten Linse (102a) ist, "d" eine optische Länge zwischen der ersten Linse (102a) und der zweiten Linse (102b) ist, "e" eine optische Länge zwischen der zweiten Linse (102b) und dem beugenden optischen Element (103) ist, $f_1$ eine Brennweite der ersten Linse (102a) ist, und $f_2$ eine Brennweite der zweiten Linse (102b) ist.

2. Laserbestrahlungsgerät nach Anspruch 1, wobei eine optische Länge zwischen dem Emissionspunkt des Laseroszillators (101) und der zweiten Linse (102b) ein Meter oder länger ist.

3. Laserbestrahlungsgerät nach Anspruch 1, wobei die erste Linse (102a) und die zweite Linse (102b) konvexe Linsen sind.

4. Laserbestrahlungsverfahren, das die folgenden Schritte umfasst:

Emittieren von Laserlicht (105) aus einem Laseroszillator (101);

Eintretenlassen des Laserlichts (105) in ein optisches System (102) zur Strahlaufweitung; und

Eintretenlassen des durch das optische System (102) zur Strahlaufweitung hindurch gegangenen Laserlichts (105) in ein beugendes optisches Element (103),

**dadurch gekennzeichnet, dass** das optische System (102) zur Strahlaufweitung eine erste Linse (102a) und eine zweite Linse (102b) in dieser Reihenfolge von einer Laseroszillator (101)-Seite aus aufweist, und

wobei der Laseroszillator (101), die erste Linse (102a), die zweite Linse (102b) und das beugende optische Element (103) so angeordnet sind, dass Gleichungen $c = f_1$, $d = f_1 + f_2$ und $e = f_2$ erfüllt werden, wo "c" eine optische Länge zwischen einem Emissionspunkt des Laseroszillators (101) und der ersten Linse (102a) ist, "d" eine optische Länge zwischen der ersten Linse (102a) und der zweiten Linse (102b) ist, "e" eine optische Länge zwischen der zweiten Linse (102b) und dem beugenden optischen Element (103) ist, $f_1$ eine Brennweite der ersten Linse (102a) ist, und $f_2$ eine Brennweite der zweiten Linse (102b) ist.

**5.** Laserbestrahlungsverfahren nach Anspruch 4, wobei eine optische Länge zwischen dem Emissionspunkt des Laseroszillators (101) und der zweiten Linse (102b) ein Meter oder länger ist.

**6.** Laserbestrahlungsverfahren nach Anspruch 4, wobei die erste Linse (102a) und die zweite Linse (102b) konvexe Linsen sind.

**7.** Verfahren zum Herstellen einer Halbleitervorrichtung, das die folgenden Schritte umfasst:

Ausbilden eines Halbleiterfilms (704) über einem Substrat (701);
Emittieren von Laserlicht aus einem Laseroszillator (101, 901); und
Bestrahlen des Halbleiterfilms (704) mit dem Laserlicht durch ein optisches System (102, 902) zur Strahlaufweitung und ein beugendes optisches Element (103, 903) unter Verwendung des Verfahrens nach einem der Ansprüche 4 - 6.

## Revendications

**1.** Appareil d'irradiation laser comprenant:

un oscillateur laser (101);
un système optique d'expansion de faisceau (102) qui reçoit un faisceau laser (105) émis par l'oscillateur laser (101); et
un élément optique diffractif (103) qui reçoit le faisceau laser (105) traversé le système optique d'expansion de faisceau (102),
**caractérisé en ce que** le système optique d'expansion de faisceau (102) comporte une première lentille (102a) et une seconde lentille (102b) dans cet ordre à partir de l'oscillateur laser (101), et
dans lequel des équations $c = f_1$, $d = f_1 + f_2$, et $e = f_2$ sont satisfaites, dans lesquelles "c" est une longueur optique entre un point d'émission de l'oscillateur laser (101) et la première lentille (102a), "d" est une longueur optique entre la première lentille (102a) et la seconde lentille (102b), "e" est une longueur optique entre la seconde lentille (102b) et l'élément optique diffractif (103), $f_1$ est une longueur focale de la première lentille (102a), et $f_2$ est une longueur focale de la seconde lentille (102b).

**2.** Appareil d'irradiation laser selon la revendication 1, dans lequel une longueur optique entre le point d'émission de l'oscillateur laser (101) et la seconde lentille (102b) est un mètre ou plus.

**3.** Appareil d'irradiation laser selon la revendication 1, dans lequel la première lentille (102a) et la seconde lentille (102b) sont des lentilles convexes.

**4.** Procédé d'irradiation laser comprenant les étapes de:

émettre un faisceau laser (105) d'un oscillateur laser (101);
faire entrer le faisceau laser (105) dans un système optique d'expansion de faisceau (102); et
faire entrer le faisceau laser (105) ayant traversé le système optique d'expansion de faisceau (102) dans un élément optique diffractif (103),
**caractérisé en ce que** le système optique d'expansion de faisceau (102) comporte une première lentille (102a) et une seconde lentille (102b) dans cet ordre à partir de l'oscillateur laser (101), et
dans lequel l'oscillateur laser (101), la première lentille (102a), la seconde lentille (102b), et l'élément optique diffractif (103) sont arrangés de manière que des équations $c = f_1$, $d = f_1 + f_2$, et $e = f_2$ soient satisfaites, dans lesquelles "c" est une longueur optique entre un point d'émission de l'oscillateur laser (101) et la première lentille (102a), "d" est une longueur optique entre la première lentille (102a) et la seconde lentille (102b), "e" est une longueur optique entre la seconde lentille (102b) et l'élément optique diffractif (103), $f_1$ est une longueur focale de la première lentille (102a), et $f_2$ est une longueur focale de la seconde lentille (102b).

**5.** Procédé d'irradiation laser selon la revendication 4, dans lequel une longueur optique entre le point d'émission de l'oscillateur laser (101) et la seconde lentille (102b) est un mètre ou plus.

**6.** Procédé d'irradiation laser selon la revendication 4, dans lequel la première lentille (102a) et la seconde lentille (102b) sont des lentilles convexes.

**7.** Procédé de fabrication d'un dispositif semi-conducteur, comprenant les étapes de:

former un film semi-conducteur (704) sur un substrat (701);
émettre un faisceau laser d'un oscillateur laser (101, 901); et
irradier le film semi-conducteur (704) par le faisceau laser à travers un système optique d'expansion de faisceau (102, 902) et un élément optique diffractif (103, 903), en utilisant le procédé selon l'une des revendications 4 à 6.

FIG. 1

EP 2 275 222 B1

FIG. 2

EP 2 275 222 B1

EP 2 275 222 B1

FIG. 3

# FIG. 4A

701  702  703  704

# FIG. 4B

704a    704b    705    704c    704d

# FIG. 4C

707    708

706b  706a
706c

# FIG. 4D

731    709  710

730a    730b    730c    730d

EP 2 275 222 B1

FIG. 5A

712     711

FIG. 5B

713

FIG. 5C

715     714

732

EP 2 275 222 B1

FIG. 6A

716

FIG. 6B

717

FIG. 7A

718

FIG. 7B

719

733

FIG. 8A

FIG. 8B

721

722

723

724

FIG. 9A

FIG. 9B

FIG. 9C

FIG. 10A

203

202    201

FIG. 10B

202  203   201

FIG. 10C

201     202    203

FIG. 10D

201    202  203

## FIG. 11A

CHECK

Place OOOOOOO
OOBankOOBlanch

Amount ¥1,234,567※

Date YYY/MM/DD
OOOOINC. (Stamp)

Place OO   President OO

80

## FIG. 11B

Name OO OO   YYYY/MM/DD
Birth OOOOOO
Address OOOOOO
YYYY/MM/DD

Number OOOOO
Others

80

## FIG. 11C

OOO Coupon
1kg

80

## FIG. 11D

Box Lunch
480 yen
△△ □□ ✕✕
OO Inc.

80

## FIG. 11E

80

## FIG. 11F

80

DVD

## FIG. 11G

80

## FIG. 11H

80

FIG. 12

EP 2 275 222 B1

FIG. 13

1101   1105   1102a   1102   1102b   1104

f₁   f₂

EP 2 275 222 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6473233 B1
- EP 1666949 A
- FR 2731085 A1
- JP H741845 B